# EUROPÄISCHE PATENTSCHRIFT

(11) **EP 2 747 533 B1**
(45) Veröffentlichungstag und Bekanntmachung des Hinweises auf die Patenterteilung: **29.11.2017**
(21) Anmeldenummer: 12198984.2
(22) Anmeldetag: 21.12.2012
(51) Int. Cl.: H05K 7/20, H05K 7/14, G08B 17/00, G05B 19/00, G08B 19/00

(54) **Elektronischer Schaltschrank mit Kühlung**
Electronic switching cabinet with cooling
Armoire électrique électronique avec refroidissement

(43) Veröffentlichungstag der Anmeldung: 25.06.2014
(73) Patentinhaber: Minimax GmbH & Co. KG, 23840 Bad Oldesloe (DE)
(72) Erfinder: Steffen, Hartwig, 21465 Reinbek (DE)

(56) Entgegenhaltungen:
- EP-A1- 2 073 618
- EP-A1- 2 479 861
- EP-A2- 1 413 997
- DE-A1- 2 211 268
- DE-A1-102009 043 455
- DE-A1-102010 002 295

## Beschreibung

Die Erfindung betrifft einen elektronischen Schaltschrank für eine Brandmelder- und/oder Löschsteuerzentrale entsprechend dem Oberbegriff des ersten Patentanspruches.

Der erfindungsgemäße Schaltschrank ist überall dort einsetzbar, wo eine Brandmelder-und/oder Löschsteuerzentrale vorhanden ist und die im elektronischen Schaltschrank befindlichen Module Wärme erzeugen, so dass sie gekühlt werden müssen.

Elektronische Schaltschränke für Brandmelder- und/oder Löschsteuerzentralen sind allgemein bekannt und bestehen aus dem Gehäuse mit einer Befestigungsmöglichkeit für Module, in denen elektronische Baugruppen angeordnet sind, wobei die Module untereinander und mit einem Außenbereich mit externen Komponenten in Verbindung stehen. Module dieser Art bestehen aus einem Gehäuse und den im Inneren angeordneten elektronischen Baugruppen.

Die in den Modulen angeordneten elektronischen Baugruppen können Schaltungsteile oder Halbleiterbauelemente enthalten, welche eine Wärmeverlustleistung erzeugen, die abgeführt werden muss. Um die elektronischen Baugruppen und deren Bauelemente im spezifizierten Temperaturbereich zu betreiben, kann es erforderlich sein, die Module, d. h. deren elektronische Baugruppen, zusätzlich zur Kühlung durch freie Konvektion, wie sie im bekannten Stand der Technik erfolgt, zu kühlen.

Eine freie Konvektion kann aber durch unterhalb und oberhalb der Module installierten Einbauten wie Kabelkanäle behindert bzw. unterbunden werden. Um die Leistungsfähigkeit einzelner Module zu erhöhen und ein höhere Wärmeverlustleistung lokal abzuführen ist die Nutzung der freien Konvektion nicht ausreichend.

Elektronische Schaltschränke im obengenannten Anwendungsbereich weisen in der Regel Module mit Lüftungsschlitzen im oberen und unteren Bereich ihres Gehäuses nahe dem Sockel auf. Derartige Modulgehäuse tragen beispielsweise die Bezeichnung Phoenix-ME10. Es werden aber auch in Funktion und Bauweise ähnliche Modulgehäuse eingesetzt.

Die Kabelanschlüsse dieser Module befinden sich in der Regel distal vom Sockel. Im mittleren Bereich dieser Module sind im Gehäuse im Wesentlichen die elektronischen Bauteile angeordnet, die bei hohen Leistungsanforderungen Wärme erzeugen, wobei bei einer mangelnden Kühlung Wärmenester entstehen, die bis zum Ablöten von Teilen aus den elektrischen Baugruppen führen können.

Daher ist eine Kühlung dieser Module im elektronischen Schaltschrank erforderlich.

Aus dem Stand der Technik sind verschiedene Lösungen zum Kühlen elektronischer Bauteile in Schaltschränken bekannt.

DE 40 35 213 C2 beschreibt ein Gehäuse mit Kühleinrichtung, in dem elektronische Baugruppen durch einen Luftstrom gekühlt werden, um Wärmestaus zu vermeiden. Gekühlt werden Platten, die sich im Gehäuse befinden, wobei sich unterhalb und oberhalb der Platten Zu- und Ableitungen für die Warm- und Kaltluft befinden, wobei die Luft allen Platten gleichmäßig zugeleitet wird und die Kaltluft mittels Gebläse erzeugt wird.

DE 26 38 118 A1 beschreibt ein Belüftungsmodul zum Kühlen elektronischer Bauteile, bei dem mehrere elektronische Bauteile übereinander angeordnet sind, wobei senkrechte Luftkanäle zum Zuführen von Kaltluft und Abführen von Warmluft dienen und waagerechte Luftkanäle oberhalb und unterhalb der zu kühlenden Platten und Magazineinheiten angeordnet sind, so dass jede zu kühlende Einheit mit einem gleichmäßigen Luftstrahl über die gesamte Fläche versorgt wird.

DE 20 2004 006 252 U1 beschreibt ein Kühlsystem für Geräte und Netzwerkschränke, welches ebenfalls waagerechte und senkrechte Luftkanäle und einen Lüfter aufweist, wobei elektronische Moduleinheiten gekühlt werden und Wärmetauscher vorhanden sind.

Bekannt aus diesem Stand der Technik sind senkrechte und waagerechte Luftkanäle in elektronischen Schaltschränken zur Kühlung von elektronischen Baugruppen.

DE22 11 268 A1 offenbart einen elektrischen Schaltschrank für elektronische Steckeinheiten, umfassend ein Gehäuse mit einer Befestigungsmöglichkeit für elektronische Baugruppen, wobei eine Kühleinrichtung zwischen zwei senkrechten Kanälen angeordnet ist. Der jeweils erste senkrechte Kanal führt einen Kaltluftstrom und der jeweils zweite senkrechte Kanal führt einen Warmluftstrom weg von den elektronischen Baugruppen. Bei den zu kühlenden elektronischen Baugruppen handelt es sich nicht um Module, die ein Modulgehäuse umfassen, in denen elektronische Baugruppen angeordnet sind. Eine schräg verlaufende Trennwand dient zum Umlenken des Luftstromes zwischen den senkrechten Kanälen.

Die elektronischen Baugruppen, die Leiterplatten und Steckelemente auf einer Kontaktleiste darstellen, die auf einen Einschub montiert sind, werden von einem Luftstrom gekühlt, der an der oberhalb und unterhalb befindlichen Trennwand umgelenkt wird. wobei der Einschub für die elektronischen Bauteile nach oben und unten komplett offen ist, so dass thermisch besonders belastete elektronische Bauteile nicht separat oder in besonderem Maße kühlbar sind. Einen waagerechten Kanal mit mehreren Öffnungen weist der Schaltschrank nicht auf.

Nachteilig an diesem vorbekannten Stand der Technik ist, dass alle elektronischen Bauteile gleichmäßig gekühlt werden, was nur dann sinnvoll ist, wenn auch alle Module die gleiche Erwärmung erfahren. In elektronischen Schaltschränken, in denen Module vorhanden sind, an denen eine unterschiedliche Erwärmung stattfindet, hat das den Nachteil, dass Module, die sich nicht erwärmen oder nur eine geringe Erwärmung aufweisen, in gleicher Weise gekühlt werden wie Module, die eine sehr hohe Erwärmung aufweisen.

Weiterhin ist nicht erkennbar, dass die vorgeschlagenen Lösungen geeignet sind, für elektronische Schaltschränke für eine Brandmelder- und/oder Löschsteuerzentrale eingesetzt zu werden, da diese Schaltschränke mit Modulen bestückt sind die sich sehr unterschiedlichen erwärmen und damit auch unterschiedlich zu kühlen sind.

Es ist daher Aufgabe der Erfindung, einen elektronischen Schaltschrank für eine Brandmelder- und/oder Löschsteuerzentrale zu entwickeln, dessen Module so gekühlt werden, dass die entstehende Wärme eines jeden Moduls mit der erforderlichen Leistung am Ort ihrer Entstehung abgeführt wird.

Diese Aufgabe wird durch einen elektronischen Schaltschrank nach den kennzeichnenden Merkmalen des ersten Patentanspruches gelöst.

Unteransprüche geben vorteilhafte Ausgestaltungen dieser Erfindung wieder.

Diese Aufgabe wird dadurch gelöst, dass in einem elektronischen Schaltschrank für eine Brandmelder- und/oder Löschsteuerzentrale eine Kühlmöglichkeit geschaffen wird, mit der nur die Module gekühlt werden, die sich erwärmen und zwar in Abhängigkeit der von ihnen erzeugten Wärme.

Die erfindungsgemäße Lösung sieht einen elektronischen Schaltschrank für eine Brandmelde- und/oder Löschsteuerzentrale vor, welcher aus einem Gehäuse mit einer Befestigungsmöglichkeit für die Module oder deren Gehäuse besteht, wobei in den Modulen Schaltschrank gezielt zu den einzelnen Modulen geführt werden. Dazu sind Kühleinrichtungen für die zu kühlenden Module im elektronischen Schaltschrank anzuordnen, die im Wesentlichen aus senkrechten und waagerechten Kanälen bestehen, d. h. in der Regel wird auf einer oder auf beiden Seiten des elektronischen Schaltschrankes durch einen senkrechten Kanal ein kalter Luftstrom zugeführt der sich durch das Kühlen erwärmt und als warmer Luftstrom auf einer oder der anderen Seite in einem senkrechten Kanal abgeführt wird.

In einer vorteilhaften Ausführungsvariante befindet sich der senkrechte Kanal zur Zuführung des kalten Luftstromes auf der jeweils entgegengesetzten Seite des elektronischen Schaltschrankes, an der der senkrechte Kanal für die abzuführende Warmluft angeordnet ist.

Vorteilhaft ist es, wenn die Kühlvorrichtung mindestens einen Lüfter aufweist. Dieser Lüfter kann innerhalb oder auch außerhalb des elektronischen Schaltschrankes angeordnet sein.

Weiterhin ist es vorteilhaft, wenn die Kühlvorrichtung mindestens einen Wärmetauscher aufweist, in dem die warme Luft für eine Wiederverwendung oder eine Wärmegewinnung abgekühlt wird.

Die im senkrechten Luftkanal zugeführte Kaltluft wird in einen oder mehrere im Wesentlichen waagerechte erste Kanäle zu den zu kühlenden Modulen geführt, wobei sich im ersten waagerechten Kanal Öffnungen für die austretende Kaltluft befinden. Die im Wesentlichen waagerechten ersten Kanäle für die Zufuhr der Kaltluft sind unterhalb des zu kühlenden Moduls, bzw. der zu kühlenden Module einer Reihe von Modulen angeordnet. Oberhalb einer jeden Reihe von Modulen ist ein im Wesentlichen zweiter waagerechter Kanal angeordnet in dem sich Öffnungen für die eintretende Warmluft befinden. Diese Öffnungen für austretende Kaltluft und für die eintretende Warmluft befinden sich an den Stellen, an denen zu kühlende Module angeordnet sind. Bei den Öffnungen kann es sich um runde, eckige, ovale und andere geeignete Öffnungen handeln.

In einer vorteilhaften Ausgestaltung der Erfindung können der waagerechte Kanal über den Modulen für die Warmluft und der darüber befindliche waagerechte Kanal unter den Modulen für die Kaltluft auch als ein Kanal mit einer Trennwand ausgebildet sein.

In einer weiteren vorteilhaften Ausführungsform werden zur Effizienzerhöhung der Kühlung für Module, die eine intensivere Kühlung erhalten, Luftführungskopplungen zwischen den Modulen und den waagerechten ersten und zweiten Kanälen angeordnet.

Die Luftführungskopplung ist eine Einrichtung zum Führen von Kalt- oder Warmluft. Sie führen den Kalt- oder Warmluftstrom möglichst verlustfrei von den Öffnungen der waagerechten Kanäle zu den Modulen oder/und deren Gehäuse und stellen die luftstrommäßige Verbindung zwischen den waagerechten Kanälen und den zu kühlenden Modulen dar.

Die Luftführungskopplung kann unterschiedliche Ausführungsformen - starr, flexibel aufweisen. An den Enden können Adapterformstücke zum Aufschnappen auf oder einrasten in die Eintritts- und Austrittsöffnungen an den Modulen und den Öffnungen an den waagerechten Kanälen ausgeführt sein.

Die Luftführungskopplungen können in halb runder, runder, ovaler, eckiger, rechteckiger und U-Form sowie in anderer geeigneter Form ausgeführt sein.
Der Luftstrom nimmt durch die Vorrichtung den folgenden Weg. Am unteren Ende des senkrechten Kanals tritt der Kaltluftstrom in die Vorrichtung ein, strömt nach oben und gelangt in die oder einen der waagerechten Kanäle der oder die sich unterhalb der Gehäuse der Module befinden. Öffnungen für die austretende Kaltluft in diesen wagerechten Kanälen befinden sich gegenüber den zu kühlenden Modulen. Die aus den waagerechten Kanälen aus diesen Öffnungen austretende Kaltluft tritt nun durch Eintrittsöffnungen am Gehäuse des zu kühlenden Moduls ein. Durch diese Eintrittsöffnungen an den Gehäusen der Module wird der Kaltluftstrom mit oder ohne Luftführungskopplung in die Gehäuse der sich erwärmenden Module geleitet wobei diese gekühlt werden. Der so entstehende Warmluftstrom verlässt die Gehäuse der Module durch die Austrittsöffnungen am Gehäuse der Module und gelangt mit oder ohne Luftführungskopplung durch die Öffnung im Wesentlichen zweiten waagerechten Kanal. Der Warmluftstrom gelangt durch den im Wesentlichen zweiter waagerechter Kanal in den senkrechten Kanal für Warmluft, wird durch diesen nach oben geleitet und kann die Vorrichtung verlassen.

Module, die elektronische Baugruppen mit geringer Wärmeverlustleistung enthalten und deren Erwärmung daher nicht so hoch ist, benötigen keine intensive und direkte Luftdurchströmung. Für diese Module genügt es, lediglich Öffnungen für Warm- und Kaltluft oberhalb und unterhalb des Moduls im waagerechten Kanal für Warm- und Kaltluft vorzusehen.

Module, die nur eine sehr geringe Leistung aufweisen oder nur sehr selten betrieben werden, benötigen keine intensivere Kühlung, so dass für Positionen im elektronischen Schaltschrank, an denen diese Module angeordnet sind, keine Öffnungen im waagerechten Kanal für Warm- und Kaltluft vorgesehen werden müssen.

Die Positionen der verschließbaren Öffnungen im waagerechten Kanal für Warm- und Kaltluft können an den betreffenden Stellen im waagerechten Kanal markiert und nach dessen Montage ausgebrochen werden. Vorteilhaft ist es weiterhin, diese durch geeignete und durch den Stand der Technik bekannte Maßnahmen bei Bedarf wieder zu verschließen. Dazu können im waagerechten Kanal beispielsweise geeignete Klappen oder Verschlussstopfen oder andere nach dem Stand der Technik bekannte Lösungen vorgesehen sein.

Damit die Module mit externen Komponenten kommunizieren können, sind auf der einen Seite der Module Anschlüsse für den Außenbereich an den Modulen angeordnet. Als externe Komponenten sind Brandmelder verschiedenster Art und Anschlusstechnologie wie Grenzwert- und Loopmelder, verschiedene Arten von Aktoren, wie Hupen, Blitzleuchten, Ventile oder Relais , sowie Feuerwehrperipherie und weitere vernetzte Zentralen vorstellbar. Diese Anschlüsse befinden sich in der Regel auf der entgegengesetzten Seite der Befestigungsmöglichkeit des Moduls. Um Kabel an diese Seite des Moduls heranzuführen, ist es vorteilhaft, am oder vor dem waagerechten Kanal einen Kabelkanal anzuordnen, in dem die Kabel an die Module herangeführt werden. Dieser Kabelkanal kann an seiner Ober-und seiner Unterseite einen Schlitz aufweisen, durch den die Kabel mit ihren Anschlüssen nach außen geführt und in die betreffenden Module von oben oder/und unten mittels Steckers eingesteckt werden können.

Die erfindungsgemäße Lösung sieht vor, dass mehrere Reihen von Modulen über- und untereinander angeordnet sind, wobei mehrere im Wesentlichen waagerechte Kanäle für Warm- und Kaltluft über- und unterhalb der Module vorzusehen sind.

Die Lösung ist selbstverständlich geeignet, auch mehrere Reihen von Modulen nebeneinander anzuordnen, wobei dann mehrere senkrechte Kanäle für Warm- und Kaltluft beidseitig der Module anzuordnen sind.

Vorteilhaft an dem elektronischen Schaltschrank ist, dass eine Kühlung der Module mit der erforderlichen Leistung und an dem Ort im elektronischen Schaltschrank erfolgt, an dem die Wärme entsteht. Dabei ist es vorteilhaft, dass bei Änderungen im Schaltschrank, wie diese beim Umstecken der Module oder durch Erweiterungen unter Hinzufügung weiterer Module erfolgen können, auch die Zufuhr der Kaltluft und die Abführung der Warmluft mit geringem Aufwand geändert werden kann.

Weiterhin ist es vorteilhaft, dass die abgeführte Wärmeenergie mittels Wärmetauschers nutzbar ist.

Im Folgenden wird die Erfindung an einem Ausführungsbeispiel und vier Figuren näher erläutert. Die Figuren zeigen:
- Figur 1:: Schematische Darstellung eines Elektronikschaltschrankes im Schnitt B-B von Figur 2
- Figur 2:: Schematische Darstellung eines Elektronikschaltschrankes im Schnitt A-A von Figur 1
- Figur 3:: Modul mit Kühlöffnungen im mittleren Bereich
- Figur 4:: Ansicht von oben auf das Modul in Figur 3.

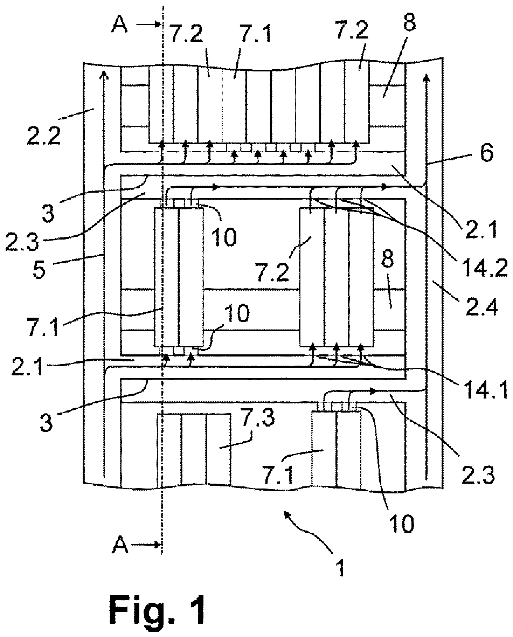

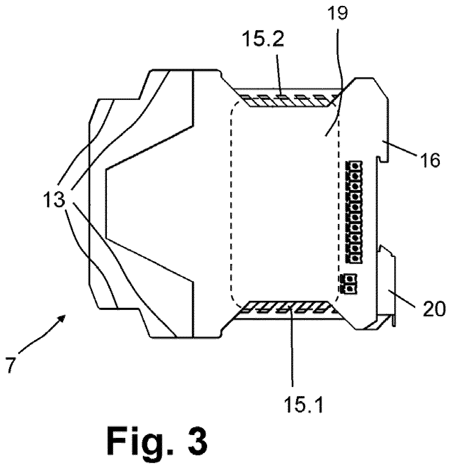

Die *Figur 1* zeigt in schematischer Darstellung einen elektronischen Schaltschrank 1, in dem unterschiedliche Module 7.1, 7.2, 7.3 angeordnet sind. Dabei handelt sich dabei um Module 7 mit einem Gehäuse der Art, wie es beispielhaft in Figur 3 gezeigt ist. Die Module können als Module 7.1 mit intensiver Kühlung, als Module 7.2 mit geringer Kühlung und/oder als Module 7.3 ohne Kühlung angeordnet sein. Die Module 7.1, 7.2, 7.3 sind mit ihrem Gehäuse lösbar auf einer Befestigungsmöglichkeit, einer Hutschiene 8 angeordnet und können untereinander verbunden sein. Durch die lösbare Anordnung der Module 7.1,7.2,7.3 auf der Hutschiene 8 besteht die Möglichkeit bei geänderter Aufgabenstellung die Module 7.1,7.2,7.3 anders im elektronischen Schaltschrank 1 anzuordnen bzw. zusätzlich zu montieren. Entsprechend dieser anderen Anordnung ist auch die Kühlung im elektronischen Schaltschrank 1 mit geringem Aufwand veränderbar. Für die Kühlung der Module 7.1,7.2 sind senkrechte und waagerechte Kanäle 2.1, 2.2, 2.3, 2.4 angeordnet, in denen ein Luftstrom mit Kaltluft 5 durch einen senkrechten Kanal 2.2 zugeführt wird und ein Luftstrom mit Warmluft 6 über einen senkrechten Kanal 2.4 abgeführt wird.
Zwischen den waagerechten Kanälen 2.1, 2.3 ist eine Trennwand 3 zum Trennen des Luftstromes von Warmluft 6 und Kaltluft 5 angeordnet.
Der Luftstrom 5,6 nimmt durch die Vorrichtung den folgenden Weg. Am unteren Ende des linken senkrechten Kanals 2.2 tritt der Kaltluftstrom 5 in die Vorrichtung ein, strömt nach oben und gelangt in die in mehreren Ebenen angeordneten waagerechten Kanäle 2.1, die sich unterhalb der Gehäuse der Module 7.1,7.2, der Modulreihen befinden. Durch Öffnungen 14.1 für den Luftaustritt in den waagerechten Kanälen 2.1 für Kaltluft zu den Gehäusen der Module 7.1,7.2 wird der Kaltluftstrom 5 mit oder ohne Luftführungskopplung 10 über die Eintrittsöffnungen 15.1 am Gehäuse der Module (in Fig. 1 nicht dargestellt) in die Gehäuse der sich erwärmenden Module 7.1,7.2 geleitet, wobei diese gekühlt werden. Der so entstehende Warmluftstrom 6 verlässt die Gehäuse der Module 7.1,7.2 durch die Austrittsöffnungen 15.2 am Gehäuse der Module (in Fig. 1 nicht dargestellt) und gelangt mit oder ohne Luftführungskopplung 10 durch die Öffnung 14.2 für den Lufteintritt in den waagerechten Kanal 2.3 für die Warmluft. Der Warmluftstrom 6 gelangt durch den waagerechten Kanal 2.3 nach rechts in den senkrechten Kanal 2.4 für Warmluft strömt diesen nach oben und kann danach die Vorrichtung verlassen.

Die Module 7.1, die eine intensive Kühlung erfordern, sind mit den waagerechten Kanälen 2.1 und 2.3 über eine Zwangskühlung verbunden, d. h. zwischen den waagerechten Kanälen 2.1 und 2.3 und dem Gehäuse des Moduls 7.1 sind Luftführungskopplungen 10 zwischen den Öffnungen 14.1 für Luftaustritt im waagerechten Kanal 2.1 und den Eintrittsöffnungen 15.1 am Modulgehäuse angeordnet durch die der Luftstrom der Kaltluft 5 dem Modul 7.1 mit intensiver Kühlung zugeführt wird und durch die Luftführungskopplungen 10 zwischen den Öffnungen 14.2 für Lufteintritt im waagerechten Kanal 2.3 und den Austrittsöffnungen 15.2 am Modulgehäuse wird der Luftstrom der Warmluft 6 von dem Modul 7.1 mit intensiver Kühlung dem waagerechten Kanal 2.3 zurückgeführt und über diesen zum Sammelkanal für Warmluft, zum senkrechten Kanal für Warmluft 2.4 geführt.

Für Module 7.2 mit einer geringen Kühlung sind die Luftführungskopplungen 10 nicht erforderlich, sondern lediglich Öffnungen 14.1, 14.2 für den Luftaustritt und für den Lufteintritt aus den und in die waagerechten Kanälen 2.1, 2.3. Diese Öffnungen 14.1, 14.2 können verschließbar sein für den Fall, dass die Module 7.2 an einer anderen Stelle angeordnet werden und eine Kühlung an der vorgesehenen Stelle nicht mehr erforderlich ist.

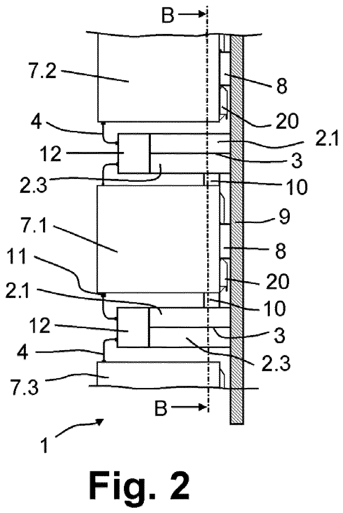

Wie der Schnitt von Figur 1 geführt ist, ist der *Figur 2* zu entnehmen.
Die Figur 2 zeigt in schematischer Darstellung einen elektronischen Schaltschrank 1 im Schnitt A-A von Figur 1. Aus dieser Darstellung ist weiterhin erkennbar, wie die Hutschienen 8 an der Montageplatte 9 des elektronischen Schaltschrankes 1 angeordnet sind. Weiterhin ist aus Figur 2 ersichtlich, dass vor den waagerechten Kühlkanälen 2.1, 2.3 mit der Trennwand 3 der Kabelkanal 12 angeordnet ist, aus dem Kabel 4 führen, die mittels Klemme 11 im vorderen Teil des jeweiligen Gehäuses des Moduls 7.1, 7.2, 7.3 befestigt sind.

Die *Figur 3* zeigt eine Ausführungsform eines Gehäuses für das Modul 7, an dem oben und unten Aus- und Eintrittsöffnungen 15.1, 15.2 angeordnet sind, durch die der Luftstrom der Kalt- und der Warmluft 5, 6 strömen kann, um die elektronische Baugruppe des Moduls 7 im Inneren des Gehäuses zu kühlen, die sich (nicht dargestellt) im mittleren Bereich 19 des Moduls 7 im Gehäuse befindet. Diese elektronische Baugruppe stellt je nach Intensität der Belastung die Wärmeentstehungszone dar, die zu kühlen ist. Auf einer Seite des Gehäuses des Moduls 7 sind die Schnappverbindung 20 und die Einrastnase 16 angeordnet, mit der das Gehäuse des Moduls 7 lösbar an der Hutschiene 8 befestigt wird. Die andere Seite weist einen Anschluss 13 für das Kabel 4 am Gehäuse des Moduls 7 auf.

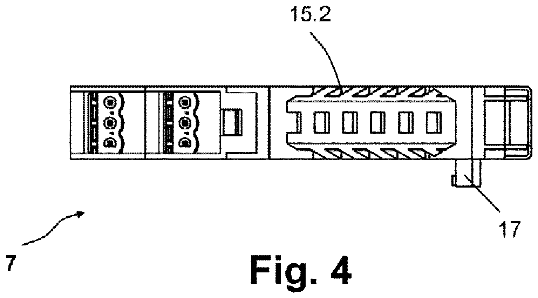

Die *Figur 4* zeigt das Gehäuse des Moduls in Ansicht von oben mit der Austrittsöffnung 15.2 und dem Stecker 17, mit dem das Modul 7 mit dem jeweils nächsten Modul 7 verbunden werden kann und eine, wie in Fig. 1 dargestellt, lückenlose Modulreihe gebildet werden kann.

### Liste der verwendeten Bezugszeichen

- 1: Elektronischer Schaltschrank
- 2.1: Kanal waagerecht für Kaltluft
- 2.2: Kanal senkrecht für Kaltluft
- 2.3: Kanal waagerecht für Warmluft
- 2.4: Kanal senkrecht für Warmluft
- 3: Trennwand
- 4: Kabel
- 5: Luftstrom Kaltluft
- 6: Luftstrom Warmluft
- 7: Modul
- 7.1: Modul mit intensiver Kühlung
- 7.2: Modul mit geringer Kühlung
- 7.3: Modul ohne Kühlung
- 8: Hutschiene
- 9: Montageplatte
- 10: Luftführungskopplung
- 11: Kabelklemme
- 12: Kabelkanal
- 13: Anschluss für Kabel am Modul
- 14.1: Öffnung in 2.1 für Luftaustritt
- 14.2: Öffnung in 2.3 für Lufteintritt
- 15.1: Eintrittsöffnungen am Gehäuse des Moduls 7
- 15.2: Austrittsöffnung am Gehäuse des Moduls 7
- 16: Einrastnase am Gehäuse des Moduls
- 17: Stecker am Gehäuse des Moduls zum Anschluss an das benachbarte Modul
- 19: Mittlerer Bereich mit Wärmeentstehungszone
- 20: Schnappverbindung gegenüber der Einrastnase am Gehäuse des Moduls 7

## Patentansprüche

1. Elektronischer Schaltschrank (1) für eine Brandmelder- und/oder Löschsteuerzentrale, umfassend ein Gehäuse mit einer Befestigungsmöglichkeit für ein Modul (7) mit einem Gehäuse, in dem elektronische Baugruppen angeordnet sind, wobei
- im Gehäuse des Schaltschrankes (1) Module (7.1) mit intensiver Kühlung, Module (7.2) mit geringer Kühlung und Module (7.3) ohne Kühlung anordenbar sind,
- wobei ferner der Schaltschrank (1) eine Kühleinrichtung für die zu kühlenden Module (7, 7.1, 7.2) mit einem im Wesentlichen waagerechten ersten und zweiten Kanal (2.1, 2.3) zwischen zwei im Wesentlichen senkrechten ersten und zweiten Kanälen (2.2, 2.4) aufweist,
- wobei der jeweils erste Kanal (2.1, 2.2) einen Luftstrom Kaltluft (5) zu den zu kühlenden Modulen (7, 7.1, 7.2) führt und der jeweils zweite Kanal (2.3, 2.4) einen Luftstrom Warmluft (6) von den zu kühlenden Modulen (7, 7.1, 7.2) wegführt und
- die waagerechten Kanäle (2.1, 2.3) Öffnungen (14.1, 14.2) für den Luftstrom der Warm- und Kaltluft (5, 6) an den Stellen aufweisen, an denen zu kühlenden Module (7, 7.1, 7.2) angeordnet sind, **dadurch gekennzeichnet, dass**
für Module (7.1), die eine intensivere Kühlung erhalten, Luftführungskopplungen (10) zwischen den Modulen (7.1) und den waagerechten ersten und zweiten Kanälen (2.1, 2.3) angeordnet sind.

2. Vorrichtung nach Anspruch 1, wobei
die Luftführungskopplungen (10) zwischen den waagerechten Kanälen (2.1, 2.3) und dem Gehäuse der Module (7.1) Luftführungskopplungen (10) aufweisen zwischen den Öffnungen (14.1) für Luftaustritt im waagerechten Kanal (2.1) und den Eintrittsöffnungen (15.1) am Modulgehäuse durch die der Luftstrom der Kaltluft (5) den Modulen (7.1) mit intensiver Kühlung zugeführt wird und Luftführungskopplungen (10) aufweisen zwischen den Öffnungen (14.2) für Lufteintritt im waagerechten Kanal (2.3) und den Austrittsöffnungen (15.2) am Modulgehäuse, durch die der Luftstrom der Warmluft (6) von dem Modul (7.1) mit intensiver Kühlung dem waagerechten Kanal (2.3) zurückgeführt und über diesen zum Sammelkanal für Warmluft, zu einem der senkrechten Kanäle für Warmluft 2.4 geführt wird.

3. Vorrichtung nach Anspruch 1 oder Anspruch 2, **dadurch gekennzeichnet, dass** die waagerechten Kanäle (2.1, 2.3) einen Kanal mit einer Trennwand (3) darstellen.

4. Vorrichtung nach einem der Ansprüche 1 bis 3, **dadurch gekennzeichnet, dass** die Kühlvorrichtung mindestens einen Lüfter aufweist.

5. Vorrichtung nach einem der Ansprüche 1 bis 4, **dadurch gekennzeichnet, dass** die Kühlvorrichtung mindestens einen Wärmetauscher aufweist.

6. Vorrichtung nach einem der Ansprüche 1 bis 5, **dadurch gekennzeichnet, dass** die Öffnungen (14.1, 14.2) Vorrichtungen zum Verschließen aufweisen.

7. Vorrichtung nach einem der Ansprüche 1 bis 6, **dadurch gekennzeichnet, dass** zwischen den Öffnungen (14.1, 14.2) und den Modulen (7.1) Einrichtungen zum Führen von Kalt- oder Warmluft (5, 6) angeordnet sind.

8. Vorrichtung nach Anspruch 7, **dadurch gekennzeichnet, dass** die Einrichtungen zwischen den Modulen (7.1) und den Öffnungen (14.1, 14.2) Luftführungskopplungen (10) in runder, halb runder, ovaler, eckiger, rechteckiger oder U-Form darstellen.

9. Vorrichtung nach einem der Ansprüche 1 bis 8, **dadurch gekennzeichnet, dass** am oder auf dem waagerechten Luftkanal ein Kabelkanal (12) angeordnet ist.

10. Vorrichtung nach Anspruch 9, **dadurch gekennzeichnet, dass** der waagerechte Kabelkanal (12) vor dem waagerechten Luftkanal angeordnet ist und ein Kabel (4) aus dem Kabelkanal (12) in den vorderen Teil des Moduls (7, 7.1, 7.2, 7.3) führt.

## Claims

1. Electronic switch cabinet (1) for a fire alarm control panel and/or for an extinguishing control panel, comprising a housing with a fastening facility for a module (7) with a housing, in which module electronic assemblies are arranged, wherein
- modules (7.1) with intensive cooling, modules (7.2) with weak cooling and modules (7.3) without cooling are able to be arranged in the housing of the switch cabinet (1),
- wherein, furthermore, the switch cabinet (1) has for the modules (7, 7.1, 7.2) to be cooled a cooling device comprising a substantially horizontal first and second duct (2.1, 2.3) between two substantially vertical first and second ducts (2.2, 2.4),
- wherein the respectively first duct (2.1, 2.2) guides an air stream of cold air (5) to the modules (7, 7.1, 7.2) to be cooled, and the respectively second duct (2.3, 2.4) guides an air stream of hot air (6) away from the modules (7, 7.1, 7.2) to be cooled, and
- the horizontal ducts (2.1, 2.3) have openings (14.1, 14.2) for the air stream of the hot and cold air (5, 6) at the positions at which modules (7, 7.1, 7.2) to be cooled are arranged,
**characterized in that**,
for modules (7.1) which are cooled relatively intensively, air-guiding couplings (10) are arranged between the modules (7.1) and the horizontal first and second ducts (2.1, 2.3).

2. Apparatus according to Claim 1, wherein
the air-guiding couplings (10) between the horizontal ducts (2.1, 2.3) and the housing of the modules (7.1) comprise air-guiding couplings (10) between the openings (14.1) for exit of air in the horizontal duct (2.1) and the inlet openings (15.1) at the module housing, through which couplings the air stream of the cold air (5) is fed to the modules (7.1) with intensive cooling, and comprise air-guiding couplings (10) between the openings (14.2) for entry of air in the horizontal duct (2.3) and the outlet openings (15.2) at the module housing, through which couplings the air stream of the hot air (6) is guided from the module (7.1) with intensive cooling back to the horizontal duct (2.3) and guided via the latter to the collecting duct for hot air, to one of the vertical ducts for hot air (2.4) .

3. Apparatus according to Claim 1 or Claim 2, **characterized in that** the horizontal ducts (2.1, 2.3) represent a duct with a separating wall (3).

4. Apparatus according to one of Claims 1 to 3, **characterized in that** the cooling device has at least one fan.

5. Apparatus according to one of Claims 1 to 4, **characterized in that** the cooling device has at least one heat exchanger.

6. Apparatus according to one of Claims 1 to 5, **characterized in that** the openings (14.1, 14.2) have devices for closing.

7. Apparatus according to one of Claims 1 to 6, **characterized in that** devices for guiding cold or hot air (5, 6) are arranged between the openings (14.1, 14.2) and the modules (7.1).

8. Apparatus according to Claim 7, **characterized in that** the devices between the modules (7.1) and the openings (14.1, 14.2) represent air-guiding couplings (10) of circular, semi-circular, oval, angular, rectangular or U-shaped form.

9. Apparatus according to one of Claims 1 to 8, **characterized in that** a cable duct (12) is arranged at or on the horizontal air duct.

10. Apparatus according to Claim 9, **characterized in that** the horizontal cable duct (12) is arranged before the horizontal air duct, and a cable (4) leads from the cable duct (12) into the front part of the module (7, 7.1, 7.2, 7.3).

## Revendications

1. Armoire électronique de commutation (1) pour centrale d'alerte incendie et/ou centrale de commande d'extinction, comprenant un boîtier doté d'une possibilité de fixation d'un module (7) dans un boîtier dans lequel des ensembles électroniques sont disposés,
des modules (7.1) à refroidissement intense, des modules (7.2) à refroidissement réduit et des modules (7.3) sans refroidissement pouvant être disposés dans le boîtier de l'armoire de commutation (1),
l'armoire de commutation (1) présentant en outre un dispositif de refroidissement pour les modules (7, 7.1, 7.2) à refroidir et présentant un premier et un deuxième canal (2.1, 2.3) essentiellement horizontaux entre deux premiers et deux deuxièmes canaux (2.2, 2.4) essentiellement verticaux,
chaque premier canal (2.1, 2.2) conduisant un écoulement d'air froid (5) vers les modules (7, 7.1, 7.2) à refroidir et chaque deuxième canal (2.3, 2.4) évacuant un écoulement d'air chaud (6) hors des modules (7, 7.1, 7.2) à refroidir,
les canaux horizontaux (2.1, 2.3) présentant des ouvertures (14.1, 14.2) pour les écoulements d'air chaud et d'air froid (5, 6) aux emplacements auxquels des modules (7, 7.1, 7.2) à refroidir sont disposés, **caractérisé en ce que**
pour les modules (7.1) qui reçoivent un refroidissement plus intense, des raccordements (10) de guidage d'air sont disposés entre les modules (7.1) et les premiers et les deuxièmes canaux (2.1, 2.3) horizontaux.

2. Ensemble selon la revendication 1, dans lequel les raccordements (10) de guidage d'air entre les canaux horizontaux (2.1, 2.3) et le boîtier des modules (7.1) présentent des raccordements (10) de guidage d'air entre les ouvertures (14.1) de sortie d'air dans le canal horizontal (2.1) et sur le boîtier de modules des ouvertures d'entrée (15.1) par lesquelles l'écoulement d'air froid (5) est amené aux modules (7.1) à refroidissement intense, et présentent entre les ouvertures (14.2) d'entrée d'air dans le canal horizontal (2.3) et les ouvertures de sortie (15.2) sur le boîtier de modules des raccordements (10) de guidage d'air par lesquels l'écoulement d'air chaud (6) provenant du module (7.1) à refroidissement intense est renvoyé dans le canal horizontal (2.3) et par ce dernier dans le canal de collecte d'air chaud et vers l'un des canaux verticaux d'air chaud (2.4).

3. Ensemble selon la revendication 1 ou la revendication 2, **caractérisé en ce que** les canaux horizontaux (2.1, 2.3) sont formés par un canal à paroi de séparation (3).

4. Ensemble selon l'une des revendications 1 à 3, **caractérisé en ce que** l'ensemble de refroidissement présente au moins un ventilateur.

5. Ensemble selon l'une des revendications 1 à 4, **caractérisé en ce que** l'ensemble de refroidissement présente au moins un échangeur de chaleur.

6. Ensemble selon l'une des revendications 1 à 5, **caractérisé en ce que** les ouvertures (14.1, 14.2) présentent des ensembles de fermeture.

7. Ensemble selon l'une des revendications 1 à 6, **caractérisé en ce que** des dispositifs d'amenée d'air froid ou d'air chaud (5, 6) sont disposés entre les ouvertures (14.1, 14.2) et le module (7.1).

8. Ensemble selon la revendication 7, **caractérisé en ce que** les dispositifs disposés entre les modules (7.1) et les ouvertures (14.1, 14.2) sont des raccordements (10) de guidage d'air de forme circulaire, semi-circulaire, ovale, polygonale, rectangulaire ou en U.

9. Ensemble selon l'une des revendications 1 à 8, **caractérisé en ce qu'**un canal (12) pour câble est disposé sur ou dans le canal d'air horizontal.

10. Ensemble selon la revendication 9, **caractérisé en ce que** le canal d'air horizontal (12) est disposé en amont du canal d'air horizontal et **en ce qu'**un câble (4) provenant du canal (12) pour câble conduit jusque dans la partie avant du module (7, 7.1, 7.2, 7.3).
